# EUROPEAN PATENT APPLICATION

(11) **EP 4 844 985 A1**
(43) Date of publication of application: **25.11.2026**
(21) Application number: 25177621.7
(22) Date of filing: 20.05.2025
(51) Int. Cl.: H02J 50/10, H02J 50/70, H05K 1/02, H05K 9/00

(54) **AN ELECTRIC SHIELD, A WIRELESS POWER TRANSFER SYSTEM, AND A METHOD FOR MANUFACTURING AN ELECTRIC SHIELD**

(71) Applicant: Hitachi Energy Ltd, 8050 Zürich (CH)
(72) Inventor: Russberg, Gunnar, 724 62 Västerås (SE); Salinas, Ener, 722 10 Västerås (SE)
(74) Representative: AWA Sweden AB

(57) **Abstract**

According to an aspect of the present inventive concept there is provided an electric shield for an electrical device, wherein the electric shield comprises a bounded portion comprising a pattern including an obstacle for stopping circulation of electrical currents induced by electromagnetic waves of a first frequency range in said bounded portion, and wherein the pattern provides anisotropic conductivity within said bounded portion such that electrical currents induced by electromagnetic waves within said bounded portion are directed in one or more specific directions, wherein the electric shield is configured for providing at least one of: an electric equipotential surface, and providing electric shielding by preventing electromagnetic waves of a second frequency range from penetrating the electric shield.

## Description

### Technical field

The present disclosure relates to electric shielding and wireless power transfer (WPT) systems. Specifically, the present disclosure relates to electric shielding for electromagnetic interference protection and WPT systems, particularly for high-voltage (HV) applications, and more specifically to electric shielding solutions that enable efficient WPT through bounded portions of electric shields.

### Background

Electromagnetic interference (EMI) poses a challenge in electronic devices and systems. Effective shielding is necessary for preventing unwanted electromagnetic radiation from disrupting sensitive circuitry and ensuring reliable operation. Traditional shielding techniques typically rely on conductive materials, such as metals, to block or absorb electromagnetic waves.

Wireless power transfer (WPT) has emerged as a promising technology for providing convenient and cable-free power delivery to electronic devices. Inductive coupling and magnetic resonance are commonly employed techniques for WPT, relying on the transfer of energy through electromagnetic fields. However, achieving efficient WPT requires careful consideration of shielding and electromagnetic compatibility (EMC) to minimize energy losses and prevent interference with other devices.

Existing shielding solutions present a trade-off between blocking electromagnetic radiation and enabling efficient wireless power transfer. Conventional shielding materials can attenuate the electromagnetic fields required for WPT, reducing the power transfer efficiency, and limiting the operating range. Conversely, allowing electromagnetic fields to pass through the shield can compromise the shielding effectiveness and expose sensitive circuitry to interference.

Furthermore, in some applications, it may be desirable to not only transfer power wirelessly but also to transmit data or signals wirelessly. This requires careful consideration of the shielding design to allow specific frequencies to pass through while blocking others, adding another layer of complexity.

Therefore, there is a need for improved shielding solutions that can effectively block unwanted electromagnetic radiation while simultaneously enabling efficient wireless power transfer and signal communication.

### Summary

An objective of the present disclosure is to provide an improved electric shield that alleviates at least some drawbacks with present solutions or improves over present solutions in at least one aspect or provides an alternative over present solutions in at least one aspect.

Further, an objective is to preferably effectively block unwanted electromagnetic interference while simultaneously enabling efficient wireless power transfer and signal communication through the electric shield.

Another objective is to provide or maintain electric field or voltage grading or guiding performance of electric shields in high-voltage AC or DC systems to reduce or maintain electric stresses on adjacent insulation materials to prevent electrical breakdown.

A further objective is to provide a wireless power transfer system utilizing an electric shield allowing for improved simultaneous power transfer efficiency and shielding capability.

Yet a further objective is to provide a method for manufacturing an electric shield that effectively blocks unwanted electromagnetic interference while simultaneously enabling efficient wireless power transfer and signal communication through the electric shield.

These and other objectives are at least partly met by the invention as defined in the independent claims. Preferred examples are set out in the dependent claims. Additional advantages and examples are described in the following.

According to a first aspect of the present disclosure there is provided an electric shield for an electrical device. The electric shield comprises a bounded portion comprising a pattern including an obstacle for stopping circulation of electrical currents induced by electromagnetic waves of a first frequency range in the bounded portion. The pattern provides anisotropic conductivity within said bounded portion such that electrical currents induced by electromagnetic waves within the bounded portion are alternating currents directed in one or more specific directions. The electric shield is configured for providing at least one of: an electric equipotential surface, and electric shielding by preventing electromagnetic waves of a second frequency range from penetrating the electric shield.

Hereby, the electric shield enables precise control of the direction of induced currents within a material of the electric shield.

The electric shield is particularly well-suited for applications involving wireless power transfer to enclosed equipment. Example applications include powering shielded electronics.

In other words, the electric shield comprises a portion with anisotropic conductivity patterns enabling effective wireless power transfer through said portion, while still allowing the electric shield to provide effective shielding.

The electric shield may be an electric shield device. The electric shield may, e.g., be a casing configured for providing electrical shielding. In an example, the electric shield may be a conductive casing, a conductive foil, and/or a metalized film.

The second frequency range may be non-overlapping with the first frequency range. The second frequency range may, e.g., comprise all frequencies below and/or above the first frequency range. In other words, the second frequency range may include frequencies that are below a minimum value or lower end of the first frequency range, and/or frequencies that are above a maximum value or upper end of the first frequency range.

The term "electric shield" as used herein may encompass broader functionality than EMI protection. The electric shield may be configured to protect an HV insulation system from electrostatic "hot spots" and/or prevent local electric breakdown, e.g., even under static (0 Hz) conditions. Furthermore, the electric shield may be configured for voltage grading, e.g., redistributing electric stresses and/or reducing electric stresses in sensitive regions or interfaces, such as solid-gas boundaries. The electric shield may hence serve a dual purpose of protecting the HV insulation and enabling the integration of sensitive electronic equipment in the HV insulation system.

The electric shield may be configured for forming or establishing a smooth (i.e., substantially uniform) surrounding electric field and/or voltage distribution, e.g., within a high-voltage insulation system. The substantially uniform surrounding electric field and/or voltage distribution may be formed to protect against local over-voltages and/or insulation material breakdown.

The bounded portion of the electric shield may generally comprise a material property modification. The material property modification may be limited to at least one sub-region within the bounded portion. In an example, the bounded portion of the electric shield may be referred to as a bounded region of the electric shield.

The bounded portion may be configured to provide resistance for induced eddy currents to form within the bounded portion of the electric shield. In particular, the bounded portion may be configured to suppress/prevent eddy currents from forming in the bounded portion while maintaining electric shielding and field distribution properties in the bounded portion of the electric shield. For example, the electric shielding and field distribution properties may be maintained at least at typical grid frequencies.

Specifically, the pattern, or material property modification, of the bounded portion may be configured to mitigate induced eddy currents in the portion. The pattern may, e.g., be configured to suppress, prevent, and/or mitigate eddy currents from forming in the bounded portion. In other words, the pattern may be configured to prevent and/or suppress induced currents from forming closed loops within the bounded portion.

The pattern allows electrical currents to flow preferentially in only limited directions. In other words, within the bounded portion, a highly conductive path may exist.

In other words, the anisotropic conductivity effectively suppresses the formation of closed-loop currents within the bounded portion, while allowing only non-circular, e.g., unidirectional, alternating currents to propagate along the surface of the electric shield within the bounded portion.

In a sense, the pattern may provide anisotropic conductivity so that electrical currents induced by electromagnetic waves encounter different conductivities within the bounded portion, thus directing the induced electrical currents in one or more specific directions within the bounded portion. Phrased differently, the electric shield incorporates anisotropic conductivity patterns that direct induced currents along predetermined paths.

The electric shield may provide galvanic contact between any two points on the electric shield. Effectively, an arbitrary point within the bounded portion may be electrically connected to any point outside of the bounded portion. Hence, galvanic connection throughout the electric shield is provided. Consequently, the electric shield remains its shielding and/or field grading capability for electromagnetic waves outside of the first frequency range (i.e., electromagnetic waves of the second frequency range).

In other words, the electric shield may be designed to provide galvanic contact between, essentially, any two points on its surface, e.g., ensuring that electric charges can move freely and that the entire electric shield is at a uniform potential, e.g., at least within a 10⁻³ second time frame.

The locally anisotropic conductivity of the electric shield, corresponding to the bounded portion, allows electric currents to flow in limited directions. Hence, there may be a highly conductive path that connects every point inside the bounded portion of anisotropic conductivity to any point outside the bounded portion, thereby allowing for efficient charge transfer and distribution of electrical potential across the electric shield.

The pattern in the bounded portion may correspond to a variation in thickness and/or resistivity of a material of the electric shield.

The anisotropic conductivity of the bounded portion may be provided by a variation in thickness and/or resistivity of a material of the electric shield within the bounded portion. The variation in thickness and/or resistivity may create a conductive landscape within the bounded portion. A plurality of variations in thickness and/or resistivity within the bounded portion may enable a precise control over the current flow within the bounded portion. Hence, the variations in thickness and/or resistivity may enable the electric shield to allow for electromagnetic waves of the first frequency range to penetrate the electric shield in the bounded portion, while still providing efficient shielding for electromagnetic waves outside of the first frequency range.

The electric shield enables both very-high-frequency EMC blocking and field grading/insulation protection. The field grading/insulation protection operates effectively even under DC static conditions, that is, in the absence of electromagnetic waves. Hence, the electric shield can provide comprehensive protection for HV insulation systems, addressing both transient electromagnetic interference and sustained static electric fields.

The pattern may comprise at least one local deformation, groove, and/or chemical modification of the material of the electric shield in said bounded portion.

The local deformation, groove, and/or chemical modification may provide the same effects and benefits as the variations in thickness and/or resistivity described above. In particular, deformations and/or grooves may correspond to variations in thickness of the material of the electric shield within the bounded portion. Generally, any deformations, grooves, and/or chemical modifications to the material of the electric shield within the bounded portion may be configured to provide variations in resistivity within the bounded portion.

The electromagnetic waves of the first frequency range may include mid-frequency electromagnetic waves, preferably in a range of 5 kHz to 20 MHz, more preferably 10 kHz to 10 MHz.

Mid-frequency electromagnetic waves may be particularly relevant for applications such as wireless power transfer and short-range communication.

The pattern within the bounded portion may be tailored to allow electromagnetic waves of the first frequency range to pass through the bounded portion. For example, the obstacle of the pattern may be arranged to prevent and/or suppress eddy currents from forming within the bounded portion in response to electromagnetic waves of said first frequency range interacting with the bounded portion. In other words, the lack of formation of eddy currents within the bounded portion may enable the electromagnetic waves of the first frequency range to pass through the electric shield within the bounded portion. The bounded portion may hence be configured to not provide shielding for electromagnetic waves of the first frequency range.

The second frequency range may include low-frequency electromagnetic waves and/or high-frequency electromagnetic waves. The second frequency range may, e.g., include frequencies lower than 10 kHz (or lower than 5 kHz). Alternatively, or additionally, the second frequency range may include frequencies above 10 MHz (or above 20 MHz).

The obstacle may be one or more anisotropic resistive elements extending in one or more directions along a surface of the electric shield to disrupt the formation of closed-loop currents within said bounded portion.

In other words, the electric shield may incorporate one or more anisotropic resistive elements within a defined portion of its surface. The anisotropic resistive elements may be oriented to extend in one or more directions along the surface of the electric shield within the bounded portion. The anisotropic resistive elements may hence create a preferential path for electrical currents to travel. The directional anisotropy disrupts the formation of closed-loop currents within the bounded portion that would otherwise arise in response to a magnetic wave penetrating the electric shield.

Hereby, by impeding the flow of current in a circular path, within the bounded portion, around a point of a penetrating magnetic wave, the anisotropic elements may suppress eddy current formation, thus, e.g., enhancing magnetic transparency and enabling efficient power transfer. Further, the orientation of the anisotropic resistive elements may ensure that any induced currents are channeled along a preferred direction. The directional anisotropy may thus enable efficient shielding and/or field grading while still allowing for power transfer through the bounded portion of the electric shield.

The pattern includes one or more obstacles configured to define one or more preferred trajectories for induced currents within the bounded portion, wherein the one or more obstacles are configured as one or more: lines, straight lines, broken lines, cross-shapes, star-shapes, and/or V-shapes within the bounded portion, and wherein the one or more preferred trajectories are substantially non-circular paths.

The pattern may comprise a network of obstacles designed to control the flow of induced currents. These obstacles may, for example, take various forms, including but not limited to etched grooves, embedded resistive strips, and/or dielectric elements. The arrangement of the obstacles may not necessarily be limited to a uniform grid. In an example, the pattern may be creating preferred trajectories for induced currents, e.g., guiding the induced currents along substantially non-circular paths. The non-circular paths may, e.g., be straight, curved, or a combination thereof. Hence, the pattern may effectively channel induced currents away from closed-loop formations within the bounded portion, mitigating formation of eddy current and thus, e.g., enabling efficient shielding at, and efficient power transfer though, the bounded portion of the electric shield.

In other words, the obstacles of the pattern may cause induced currents within the bounded portion to exit the bounded portion in non-circular paths.

According to a second aspect of the present disclosure, there is provided a wireless power transfer (WPT) system comprising: a power source coupled to an emitter; an electrical device comprising a receiver; and an electric shield according to the first aspect, wherein said electrical device is at least partly covered by said electric shield and wherein the emitter is configured to transfer electric power from the power source to the receiver of the electrical device via said bounded portion of said electric shield.

This aspect may generally present the same or corresponding advantages as the former aspect.

Hereby, the anisotropic conductivity and controlled current flow within the bounded portion provides enhanced efficiency and performance of WPT systems while still providing efficient electric shielding. In particular, by directing electromagnetic waves of the first frequency range, configured to transfer the electric power, through the bounded portion of the electric shield, energy losses are minimized, and effective power transfer is provided. Hence, there is enabled an efficient WPT system in which an electrical device configured to receive electric power is arranged within, or behind, an electric shield. The WPT system may be particularly suited for applications where a localized power delivery is sought. Generally, the WPT system provides a combination of effective shielding with effective power delivery through a bounded portion of the electric shield.

The emitter and receiver may be arranged on opposite sides of the electric shield along a transmission trajectory, and the transmission trajectory may at least partly intersect the bounded portion of said electric shield.

Hence, the electric power, i.e., electromagnetic waves of the first frequency range, may be configured to travel along the transmission trajectory. In other words, the power transferring electromagnetic waves generated by the power source and emitter may travel along the transmission trajectory to, subsequently, travel through the bounded portion of the electric shield and thus be received by the receiver.

The WPT system may comprise a plurality of electric shields, wherein the plurality of electric shields is arranged such that the bounded portions of the plurality of electric shields are at least partly overlapping.

In an example, a plurality of, e.g., layered, electric shields may be used for high-voltage bushings and/or other applications requiring a high degree of shielding. A bushing may comprise multiple concentric electric shields, e.g., wrapped around a conductor rod. Each electric shield may be provided with a bounded portion that allows for magnetic flux to pass through while maintaining electrical shielding properties. Generally, the use of a plurality of electric shields with bounded portions as discussed herein may provide enhanced flexibility and scalability in the design of wireless power transfer systems, e.g., enabling efficient transfer of power through complex geometries and/or multi-layered structures.

Further, one or more electric shield of the plurality of electric shields may be at least partly encased in an insulator, such as epoxy. The insulator may provide electrical isolation and/or mechanical support. The insulator may prevent short circuits between adjacent shields, e.g., ensuring safe and reliable operation, particularly in high-voltage applications. Further, the insulator may provide a barrier against environmental factors such as moisture and/or contaminants. An insulator may also contribute to structural integrity of the WPT system, e.g., protecting the electric shields from mechanical stress and/or vibration.

In context of bushings, the electric shields may be referred to as bushing condenser foils or metalized films. For bushings, the electric shields may not necessarily provide electric shielding. In particular, the electric shields may not necessarily provide electric shielding for high-frequency electromagnetic waves. Instead, these electric shields may primarily function as field grading elements, e.g., ensuring uniform electric stress distribution within an insulation system and/or preventing dielectric breakdown. Unless the frequency is less than approximately 100 kHz, even relatively thin conductive foils (e.g., 10 µm) will significantly attenuate or block magnetic fields attempting to penetrate the bushing insulation. This is due to the induction of planar eddy currents within the conductor, resulting in a skin depth that is critically small at frequencies exceeding 100 kHz. Lowering the frequency to below 100 kHz, however, leads to bulky and intrusive components, making it impractical for integration within the confined space of a bushing.

The WPT system forming a bushing comprising a plurality of concentric electric shields (i.e., conductive foils) as discussed herein comprises localized modifications in a bounded portion of each conductive foil to suppress eddy currents while maintaining the essential field grading and insulation properties. In other words, the bounded portions here allow for increased magnetic field penetration without compromising the overall field distribution characteristics, e.g., at typical grid frequencies (such as 50/60 Hz). Moreover, the modification may be localized to one or more specific bounded regions or extended across the entire foil surfaces, e.g., depending on the desired level of magnetic permeability.

The electrical device may be a component configured to receive power via electromagnetic waves of the first frequency range.

The electrical device may be any electrical equipment, e.g., configured to receive power. The electrical device may be configured to receive power from the power source. In other words, the power source may be configured to provide wireless power to the electrical device. In particular, said wireless power may be transferred from the power source to the electrical device via the electromagnetic waves of the first frequency range.

The electrical device may further be configured to receive and/or transmit information via said electromagnetic waves of said first frequency range.

In other words, the WPT system may be provided with means for wireless communication. For example, the electrical device may be configured to be wirelessly and communicatively connected to an external device. Said external device may be configured to receive and/or transmit signals comprising information from and/or to the electrical device being at least partly cover by the electric shield.

This communication capability may enable functionalities such as remote monitoring of electrical device status, control of electrical device operation, and/or arbitrary data exchange. For instance, the electrical device may transmit sensor data, e.g., temperature and/or pressure, to an external monitoring system. In addition, or alternatively, the electrical device may be configured to receive control commands, e.g., to adjust operating parameters.

Further, by utilizing electromagnetic waves within the first frequency range for both power transfer and communication, it may be ensured that efficient power transfer and communication is enabled when the corresponding electromagnetic waves travel through the bounded portion of the electric shield.

Electromagnetic waves used for power transfer may correspond to a first subset of the first frequency range. Similarly, electromagnetic waves used for communication may correspond to a second subset of the first frequency range. The first subset and the second subset may, e.g., be distinct or overlapping subsets.

Furthermore, the electric shield may mitigate interference, i.e., provide shielding, from other wireless devices by ensuring that reliable communication is only provided when traveling via the bounded portion.

The emitter may be an emitter coil or antenna configured to transfer electric power via magnetic resonance, and/or the receiver may be an LC-resonator.

Hence, for example, the use of an emitter coil or antenna allows for the creation of a resonant magnetic field. The LC-resonator at the receiver side may be tuned to resonate at a same frequency as the resonant magnetic field.

According to a third aspect of the present disclosure, there is provided a method for manufacturing an electric shield according to the first aspect. The method comprises: providing a conductive material; and forming a bounded portion in the conductive material with a pattern including an obstacle for stopping circulation of electrical currents induced by electromagnetic waves of a first frequency range in said bounded portion, wherein the conductive material is configured for providing at least one of: an electric equipotential surface, and electric shielding by preventing electromagnetic waves of a second frequency range from passing through said conductive material.

This aspect may generally present the same or corresponding advantages as the former aspects.

The method generally enables the fabrication of an electric shield comprising a bounded portion with anisotropic conductivity providing controlled, or limited, current flow within said bounded portion. The method allows for precise control over the electric shield's electromagnetic properties within the bounded portion, e.g., enabling high-performance shielding while further enabling power to be efficiently transferred to an electrical device configured to be arranged within or behind the electric shield.

The electric equipotential surface may form a smooth (i.e., substantially uniform) surrounding electric field and/or voltage distribution, e.g., within a high-voltage (HV) insulation system.

The pattern may correspond to a variation in thickness and/or resistivity, wherein the variation in thickness and/or resistivity may be obtained by deforming, milling, and/or chemically treating the conductive material in said bounded portion.

However, any suitable processing steps and/or methods may be used for creating the pattern or the variation in thickness and/or resistivity. The method may, e.g., comprise manufacturing techniques such as etching, laser ablation, and/or additive manufacturing. Additive manufacturing techniques may, e.g., be employed on a base dielectric film or foil.

In an example, the method may involve removal of material, mechanical deformation, and/or transformation of material properties applied to a raw metalized film or foil with homogeneous and isotropic conductivity.

Effects and features of the first, second, and third aspects are largely analogous. Examples mentioned in relation to the first, second, and third aspects are largely compatible. It is further noted that the disclosure relates to all possible combinations of features unless explicitly stated otherwise.

Generally, all terms used in the claims are to be interpreted according to their ordinary meaning in the technical field, unless explicitly defined otherwise herein. All references to "a/an/the [element, device, component, means, step, etc.]" are to be interpreted openly as referring to at least one instance of said element, device, component, means, step, etc., unless explicitly stated otherwise.

### Brief description of the drawings

The above, as well as additional objects, features, and advantages of the present inventive concept, will be better understood through the following illustrative and non-limiting detailed description, with reference to the appended drawings. In the drawings like reference numerals will be used for like elements unless stated otherwise.
Fig. 1 is a schematic illustration of a wireless power transfer system comprising an electric shield protecting, e.g., surrounding insulation (not explicitly shown) from breakdown by electrostatically enclosing equipment inside of the electric shield, and providing high-frequency EMI/EMC protection for frequencies that are greater than a frequency of the wireless power transfer system.
Figs. 2A-F are schematic illustrations of bounded portions of electric shields, where the bounded portions comprise patterns including exemplary obstacles for stopping circulation of electrical currents within the bounded portions.
Figs. 3A-B are schematic illustrations of a bounded portion of an electric shield with anisotropic conductivity allowing vertical alternating currents to flow within the bounded portion while suppressing circulating currents within the bounded region.
Figs. 4A-F are schematic illustrations of exemplary patterns in bounded portions of electric shields.
Figs. 5A-D are further schematic illustrations of exemplary patterns on electric shields.
Figs. 6A-F are schematic illustrations of electromagnetic waves interacting with electric shields.
Figs. 7A-E are schematic illustrations of examples in which a plurality of electric shields is used, such as in a bushing.
Fig. 8 shows a block diagram of a method for manufacturing a magnetic shield.

### Detailed description

Hereinafter, the principle of the present disclosure will be described with reference to illustrative examples. All these examples are given for the person skilled in the art to better understand and further practice the present disclosure, but not necessarily for limiting the scope of the present disclosure. For example, features illustrated or described as part of one example may be used with another example to yield still a further example. In the interest of clarity, not all features of an actual implementation are described in this specification. It will be appreciated that in the development of any such actual example, numerous implementation-specific decisions should be made to achieve the developers' specific goals, such as compliance with system-related and business-related constraints, which will vary from one implementation to another. Moreover, it will be appreciated that such a development effort might be complex and time-consuming but would nevertheless be a routine undertaking for those of ordinary skill in the art having the benefit of this disclosure.

The disclosed subject matter will now be described with reference to the attached drawings. Various structures, systems and devices are schematically depicted in the drawings for purposes of explanation only and to not obscure the description with details that are well known to those skilled in the art. Nevertheless, the attached drawings are included to describe and explain illustrative examples of the disclosed subject matter. The words and phrases used herein should be understood and interpreted to have a meaning consistent with the understanding of those words and phrases by those skilled in the relevant art. No special definition of a term or phrase, i.e., a definition that is different from the ordinary and customary meaning as understood by those skilled in the art, is intended to be implied by consistent usage of the term or phrase herein. To the extent that a term or phrase is intended to have a special meaning, i.e., a meaning other than that understood by skilled artisans, such a special definition will be expressly set forth in the specification in a definitional manner that directly and unequivocally provides the special definition for the term or phrase.

It is herein appreciated that high-voltage power systems and devices routinely employ electrically conductive materials for shielding, field shaping, and protection. These materials commonly take the form of plates, shells, foils, or coatings, often extending in two dimensions. In standard 50/60 Hz alternating current (AC) systems, the required thickness of electric shields is typically low (e.g., 1 µm - 1 mm), although thicker structures (e.g., >10 mm) may be used in mechanical support structures. Examples include dry capacitors utilizing metalized dielectric films, e.g., having a thickness of 1-10 µm, and metal plate casings for sensitive electronic equipment, e.g., have a thickness of 0.5-3 mm.

The inventors of the subject-matter of the present disclosure have realized that applying WPT to power devices within these shielded environments presents significant challenges. Conventional WPT relies on magnetic resonance coupling between an emitter and a receiver. However, the effectiveness of this coupling is severely limited by the conductive shielding, which tends to block or attenuate the magnetic fields at frequencies above a certain limit. The upper frequency limit (*f_{c}*) is determined by the skin depth, which is inversely proportional to the frequency and directly related to the conductivity and permeability of the shielding material. The formula relating skin depth to frequency and requiring the skin depth to be at least twenty times the shield thickness (d) is: ${f}_{c} \approx \frac{ρ}{400 π μ {d}^{2}}$ where *ρ* is the electrical resistivity and *µ* is the magnetic permeability.
For example, a 10 µm (microns) thick aluminum shield has a limit around 180 kHz, while a 1 mm shield is limited to approximately 18 Hz. Using frequencies below this range necessitates bulky and intrusive WPT components, making it impractical for many applications.

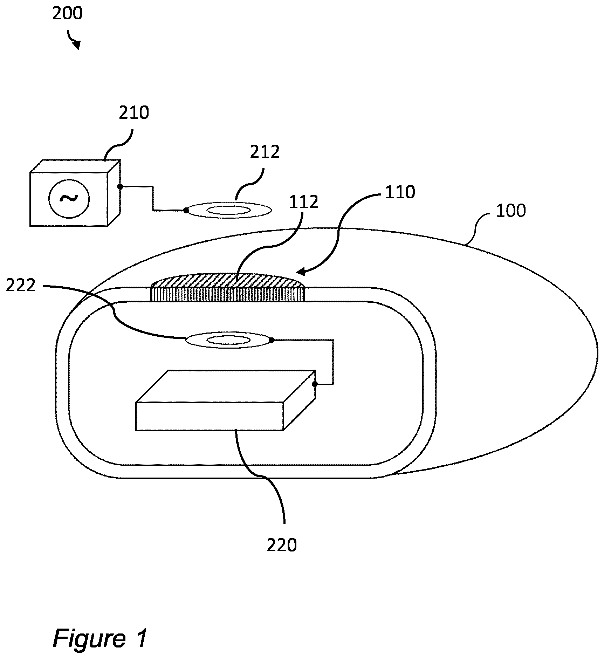

Fig. 1 schematically illustrates a wireless power transfer (WPT) system 200 comprising: a power source 210 coupled to an emitter 212; an electrical device 220 comprising a receiver 222; and an electric shield 100 at least partly covering the electrical device 220. The electric shield 100 comprises a bounded portion 110 comprising a pattern including obstacles 112 for stopping circulation of electrical currents induced in the bounded portion 110 by electromagnetic waves of a first frequency range. In particular, the pattern provides anisotropic conductivity within the bounded portion 110 such that electrical currents induced by electromagnetic waves within the bounded portion 110 are alternating currents directed in one or more specific directions. The electric shield 100 is further configured for providing an electric equipotential surface and/or electric shielding by preventing electromagnetic waves of a second frequency range from penetrating the electric shield 100.

In a sense, Fig. 1 illustrates a representative example of a WPT system 200 utilizing the disclosed electric shield 100. In particular, the electrical device 220, e.g., any electronic equipment, is enclosed within a conductive casing functioning as the electric shield 100 and providing electromagnetic containment. The power source 210 here drives the emitter 212, establishing an alternating magnetic field. This field is coupled via magnetic resonance to the receiver 222 positioned within the electric shield 100, facilitating wireless power delivery.

Phrased differently, the emitter 212 is configured to transfer electric power from the power source 210 to the receiver 222 of the electrical device 220 via the bounded portion 110 of the electric shield 100. Hence, the electrical device 220 may be a component configured to receive power via electromagnetic waves of the first frequency range.

Hence, the anisotropic conductivity implemented within the bounded portion 110 of the electric shield 100 enables efficient magnetic coupling despite the presence of the electric shield 100. This localized modification to the material properties of the electric shield 100 allows magnetic flux to penetrate the electric shield 100 while maintaining effective electromagnetic shielding, thereby enabling wireless power transfer to the enclosed electrical device 220 without significant loss.

The anisotropic conductivity within the bounded region 110 of the electric shield 100 may be achieved through a localized material property modification designed to resist induced currents forming circulating closed loops. This modification effectively creates a "window" for magnetic field penetration, enabling wireless power transfer through the bounded portion 110 of the electric shield 100.

Alternatively, or additionally, the electrical device 200 may be configured to receive and/or transmit information via electromagnetic waves within said first frequency range.

In an example, the electromagnetic waves of the first frequency range may include mid-frequency electromagnetic waves, preferably in a range of 5 kHz to 20 MHz, or more preferably 10 kHz to 10 MHz.

In Fig. 1, the emitter 212 and receiver 222 are illustrated as a generic emitter 212 and a generic receiver 222. However, the emitter 212 may, e.g., be an emitter coil or antenna configured to transfer electric power via magnetic resonance, and/or the receiver 222 may, e.g., be an LC-resonator.

Further, as seen in Fig. 1, the electric shield 100 may have a thickness substantially smaller than an extension of a surface of the electric shield.

Furthermore, although not explicitly shown in the drawings, an electric shield 100 may comprise a plurality of bounded portions 110.

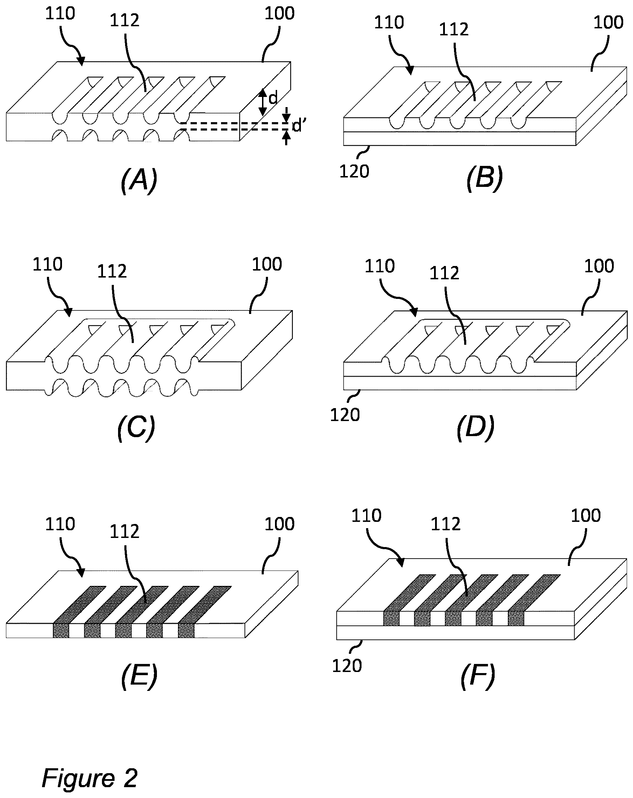

Figs. 2A-F schematically illustrate diverse obstacle configurations 112 forming a pattern within bounded portions 110 of electric shields 100, designed to prevent or mitigate the formation of circulating currents within the bounded portions 110. Generally, the purpose of these obstacles 112 is to promote current flow preferentially in one or more specific directions, thereby reducing eddy current losses and facilitating efficient magnetic field penetration for electromagnetic waves within the first frequency range. In essence, the obstacles 112 function as anisotropic resistive elements extending in directions along the surface of the electric shield 100, disrupting the formation of closed-loop currents within the bounded portion 110.

Figs. 2B, 2D, and 2F, respectively, depicts the electric shield 100 being arranged (e.g., as a coating) on a dielectric base material 120. However, the patterns depicted in Figs. 2B, 2D, and 2F may be provided directly on the electric shield 100 without the presence of a dielectric base material 120.

In Figs. 2A-F, the obstacles 112 in the bounded portions 110 correspond to variations in thickness and/or resistivity of a material of the electric shield 100. Particularly, in Figs. 2A-D, the obstacles 112 in the bounded portions 110 correspond to variations in thickness of the material of the electric shield 100. The variations in thickness, in turn, provide variations in resistivity within the bounded portions 110.

Hence, anisotropic conductivity may be implemented within the bounded portion 110 as geometric modifications, e.g., grooves, slots, or selective material removal (Figs. 2A-B), or local material deformations (Figs. 2C-D). Thus, examples of thickness modifications are shown in Figs. 2A-D. The intended physical consequence of these modifications is to create a varying cross-sectional area and a reduced thickness (d') in a current path. This results in a locally increased resistance (proportional to the ratio *d*/*d*'). Consequently, the effective resistivity perpendicular to the groove direction can reach very high values if d' is significantly smaller than d. By further providing a dielectric base 120, the dielectric base may mechanically support even a thickness d' of zero (or at least close to zero), thus e.g., allowing virtually infinite resistivity.

On the other hand, Figs. 2E-F depict obstacles 112 corresponding to variations in resistivity within the bounded portion 110. The obstacles 112 are here provided by local material modifications. The local material modifications may provide altering composition or structure in the material of the electric shield 100 within the bounded portion 110. The obstacles 112 may, e.g., correspond to chemical modifications in the material of the electric shield 100 in said bounded portion 110.

In an example, the obstacles 112 may have been formed by selective material replacement. For example, material of the electric shield 100 may be selectively removed within the bounded portion 110 and, subsequently, replaced with another material having material properties being different from material properties of the material of the electric shield 100 (the another material may, e.g., have a higher resistivity).

In Figs. 2E-F, the electrical resistivity modifications, i.e., obstacles 112, are depicted as stripes. The obstacles 112 in Figs. 2E-F may, e.g., be embedded stripes of a high-resistive material, providing an increase in magnetic transparency while retaining planar shape and electrostatic shielding properties. In particular, the intended physical consequence is here to create a high effective resistivity perpendicular to the extension of the stripes, i.e., obstacles 112. The high effective resistivity may arise from a high resistivity (ρ') of the stripe material (relative to the material of the electric shield 100). These stripes are structurally integrated into the foil, contributing to mechanical form stability.

Although not explicitly shown in the drawings, the pattern and/or obstacles 112 may be provided through additive manufacturing, e.g., creating patterned conductive structures by adding material within the bounded portion 110. For example, additive manufacturing techniques like metal 3D-printing may be applied to produce electric shields 100 and/or patterns of any form.

Further, additive manufacturing techniques may also be applied to a base dielectric film 120, an electric shield 100 (e.g., in the form of a foil, a plate, a shell, or a casing), or to any insulating body with sufficiently smooth surface. In some examples, dry-capacitor manufacturing techniques may be adapted to produce patterned metalized films, electronic circuit printing technology may be applied to foils or flat base plates, and/or vaporization or sputtering may be utilized.

A further example, not explicitly shown in the drawings, involves a uniform reduction of thickness across the entire bounded portion 110. While this solution reduces eddy currents, it may be less efficient in maintaining the required electric shielding functionality, as d' cannot be reduced close to zero. In a similar manner, although not shown in the drawings, an (isotropic) even increase of the resistivity over the entire bounded portion 110 may be provided. Such a solution reduces eddy currents within the bounded portion but may be less efficient in ensuring a proper electric shielding functionality, as *ρ*' cannot be chosen arbitrarily high.

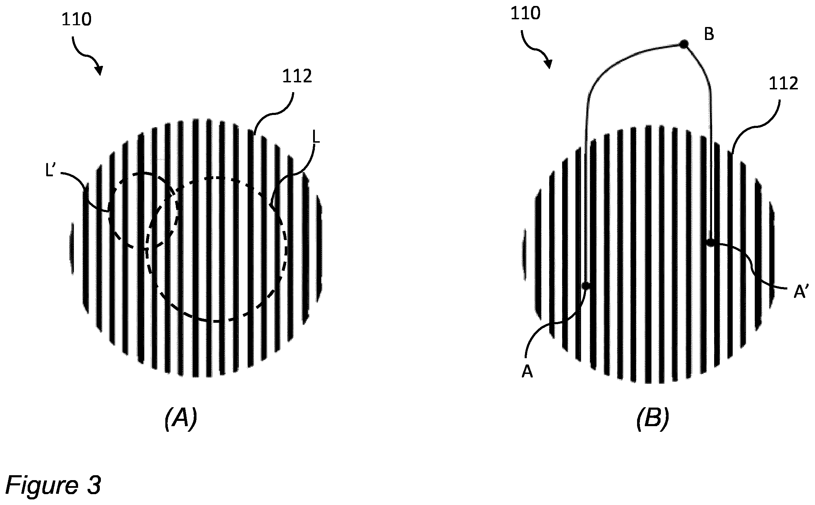

Figs. 3A-B illustrate an example of a bounded portion comprising a pattern including obstacles 112 arranged as parallel stripes. The electric shield 100 hence exhibits local anisotropic conductivity, preferentially allowing electric currents to flow in a vertical direction, as indicated by extension of the stripe pattern. In particular, the stripes, i.e., obstacles 112, here indicate material with either reduced thickness or increased resistivity compared to an unaltered material of the electric shield 100, while the (white) background represent regions or stripes of unaltered, low-resistive, and/or high-conductive material of the electric shield 100.

Fig. 3A demonstrates that, within the bounded region of anisotropic conductivity, circulating currents are effectively suppressed. The anisotropy resists the formation of closed paths (loops L, L'), allowing only vertical alternating currents to propagate. This is achieved through the pattern created by the obstacles 112, in turn creating a preferential pathway for vertical current flow.

Fig. 3B illustrates the existence of a highly conductive path connecting every point A inside the bounded portion 110 to any point B on the electric shield 100 outside of the bounded portion 110, and consequently to any other point A' inside the bounded portion 110. This ensures galvanic connection between points inside and outside the bounded portion 110, thus maintaining electrical continuity. Phrased differently, the electric shield 100 provides galvanic contact between any two points on the electric shield 100. Hence, to ensure effective shielding performance, the electric shield 100 provides galvanic contact between essentially any two points on its surface, thus maintaining a substantially uniform potential distribution and minimizing impedance.

As depicted in Fig. 3B, the configuration of obstacles 112 effectively channels current flow in preferred directions within the bounded portion 110, mitigating eddy current losses and providing efficient magnetic field penetration for electromagnetic waves within the first frequency range. Low frequency alternating currents, e.g., at or below 50 Hz, may level out potential differences between conducting paths and create low-field regions in the gaps between the conducting paths. Assuming the gaps (i.e., obstacles) are similar or narrower in width than the conductive paths, the WPT system will induce superposed medium frequency alternating currents in the conductive paths, albeit of negligible intensity compared to the 50 Hz component. In such cases, the obstacle thickness is not zero, the obstacle will provide a continuous conductive layer having a blocking effect on high-frequency fields.

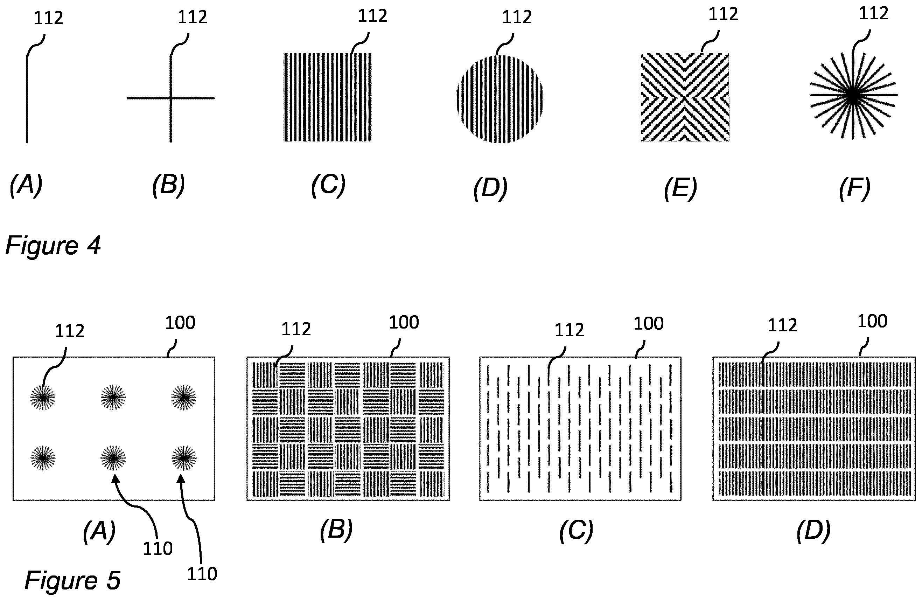

Figs. 4A-F depicts different exemplary patterns. In particular, Figs. 4A-F schematically illustrate one or more obstacles 112 configured to define one or more preferred trajectories for induced currents within the bounded portion 110.

In Fig. 4A the pattern consists of one obstacle 112 provided as one straight line.

In Fig. 4B, the obstacles 112 are arranged such that the pattern, and obstacles, forms a cross-shape.

In Fig. 4C, the pattern comprises a plurality of parallel and equally long linear obstacles 112.

In Fig. 4D the pattern comprises a plurality of parallel linear obstacles 112 forming a circular bounded portion.

In Fig. 4E, the obstacles 112 are arranged as a plurality of V-shapes of different sizes and orientations.

In Fig. 4F, the obstacles 112 are arranged in a star-shape. Phrased differently, a plurality of linear obstacles 112 are arranged and rotated relative to each other around a common center point of the plurality of linear obstacle 112.

Generally, the pattern and obstacle(s) 112 are provided such that the one or more preferred trajectories of electrical currents, within the bounded portion 110, are substantially non-circular paths.

Figs. 5A-D illustrate examples of resistivity patterns distributed across the entire electric shield 100, here realized as a sheet (e.g., of conductive foil).

Fig. 5A depicts a configuration utilizing isolated pattern islands to form a plurality of bounded portions 110. This approach creates discrete regions of modified conductivity. The isolated pattern islands act as anisotropic regions, directing current flow within the plurality of bounded portions 110 in non-circular pathways, effectively creating a plurality of windows for electromagnetic waves of the first frequency range to pass though in the plurality of bounded portions 110. In Fig. 5A, the star-shaped pattern of Fig. 4F is used to form the isolated bounded portions 110, however, any suitable pattern and/or combination of patterns can be utilized.

Figs. 5B-5D demonstrate densely patterned electric shields 100, enabling virtually any position to be electromagnetically transparent for the first frequency range. In particular, the configurations in Fig. 5B-D utilize different fine networks of conductive and non-conductive regions. The dense patterning allows for precise control over the distribution induced currents, enabling tailored shielding and efficient wireless power transfer through virtually any portion of the electric shield 100.

However, sufficient galvanic connections should still be maintained throughout the electric shield 100. By having sufficient conductive pathways, charges can establish an equal potential across the electric shield 100, e.g., within a required relaxation time. This ensures effective electromagnetic shielding and prevents localized charge buildup, which could disrupt the performance of a wireless power transfer system. The density and arrangement of conductive pathways throughout the electric shield 100 may therefore be provided such as to balance electromagnetic transparency with electrical conductivity, and thus to maintain a uniform potential distribution across the surface of the electric shield 100.

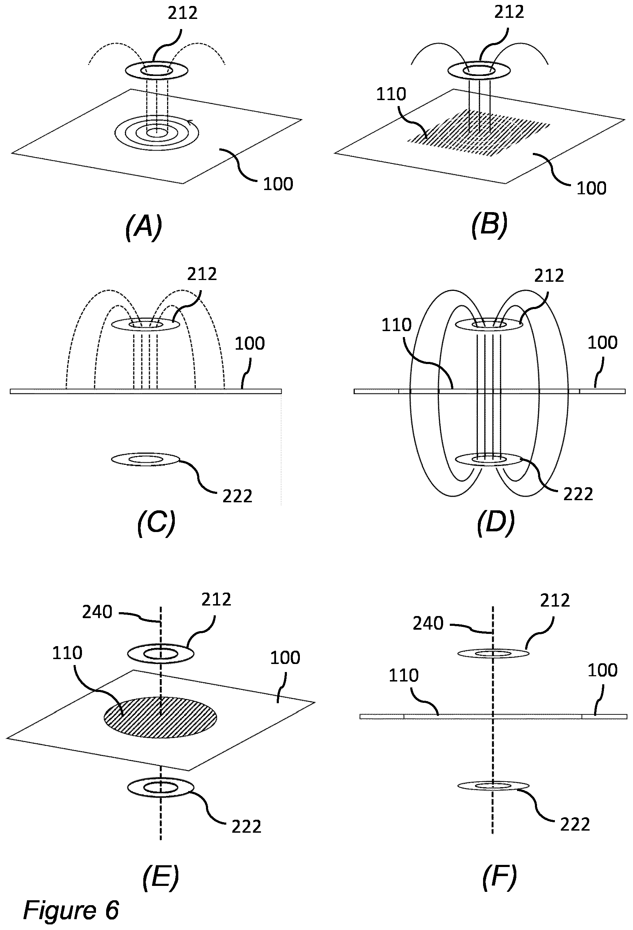

Figs. 6A and 6C illustrate the formation of eddy currents within a conductive electric shield 100 when exposed to an alternating magnetic field. These eddy currents circulate within the conductive material of the electric shield 100, dissipating energy and limiting the efficiency of wireless power transfer. The circulating currents create an opposing magnetic field, reducing the overall magnetic flux and hindering electromagnetic propagation through the electric shield 100.

Figs. 6B and 6D demonstrate the effect of a bounded portion 110 designed to prevent or reduce the formation of eddy currents within the bounded portion 110. By implementing anisotropic conductivity or strategically modifying the material properties within this bounded portion 110, the formation of closed-loop currents is suppressed within the bounded portion 110. This effectively creates a window for magnetic resonance coupling and electromagnetic propagation.

By suppressing eddy currents from forming within a bounded portion 110 of the electric shield 100, an increase in power transfer range is further obtained. By reducing energy losses due to eddy currents, the efficiency of the WPT system 200 is improved. The window created by the bounded portion hence facilitates enhanced magnetic field penetration, enabling more effective coupling between the transmitter 212 and the receiver 222 and extending the range of wireless power transfer.

Further, as depicted in Figs. 6E-F, the emitter 212 and the receiver 222 are arranged on opposite sides of the electric shield 100 along a transmission trajectory 240, wherein the transmission trajectory 240 intersects the bounded portion 110 of said electric shield 100. In particular, the transmission trajectory 240 intersects the bounded portion 110 substantially perpendicularly to a surface of the electric shield 100 within the bounded portion 110.

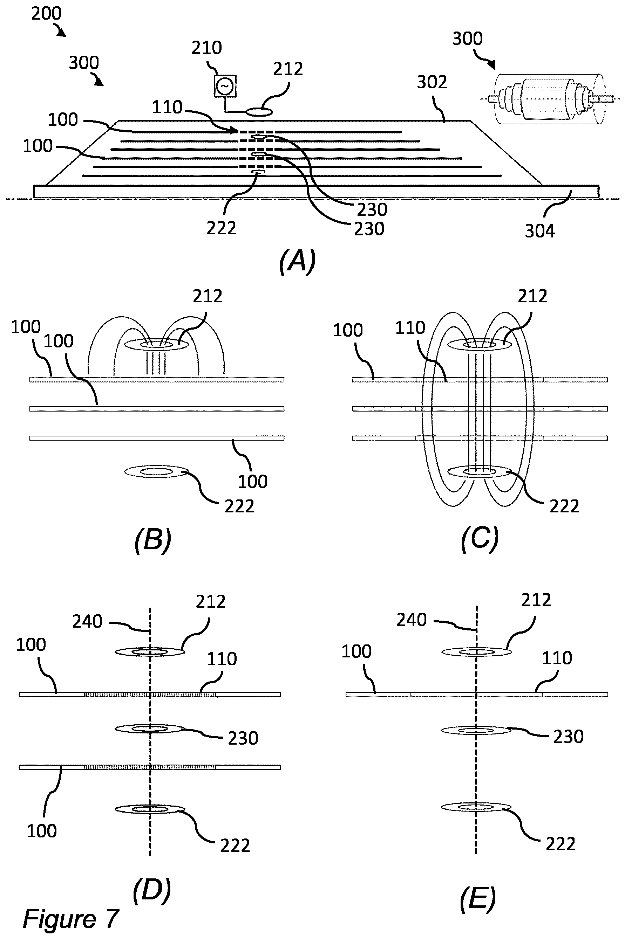

Fig. 7A illustrates a WPT system 200 for application in a high-voltage bushing 300. The WPT system 200 here comprises a plurality of electric shields 100 arranged concentrically, with the bounded portions 110 of each electric shield 100 overlapping. This arrangement is well-suited for applications, such as, powering sensors or monitoring physical quantities deep within a bushing insulation body.

More specially, Fig. 7A schematically illustrates an example of this arrangement within a resin-impregnated paper (RIP) bushing 300 with a RIP bushing insulation body 302 and a conductor rod 304. A power source 210 feeds a source coil 212 coupled via magnetic resonance to a receiver 222, which may be configured to energize a sensor (not shown in Fig. 7A). Further, two intermediate resonators 230 are provided to enhance the range and efficiency of the power transfer. However, an optional array of intermediate resonators 230 (such as an array of LC resonators) may be provided to enhance the range and efficiency of the power transfer. The magnetic coupling is enabled by the bounded portions 110, which are designed to suppress eddy currents from forming within the bounded portions 110.

In other words, the bushing 300 utilizes wireless power transfer along an essentially radial direction via magnetic resonance. The WPT system 200 comprises an external emitter 210 injecting electric power to a receiver 222 embedded within the bushing insulation. The electric shields 100, i.e., bushing condenser foils, provides galvanic contact for field grading functions while incorporating the bounded portions 110 with patterns including obstacles to resist formation of induced circular currents and facilitate magnetic field penetration.

Although not explicitly shown in the drawings, a RIP-bushing geometry and a bushing monitoring system may be provided to use magnetic resonance for direct analog sensing and for powering, e.g., using a standard digital sensor with a communication unit. Such a configuration may comprise a bushing insulation body (e.g., OIP or RIP), a condenser insert, a conductor rod or tube, a power source, an impedance analyzer, an emitter coil, an intermediate LC-resonator, a receiver LC-resonator, a rectifier, a sensor, a digital analyzer and communication unit, and an external digital communication device (e.g., Wi-Fi).

Generally, for power transformer bushings employing RIP with embedded aluminum foils, the electric shields 100 may have a thickness of, e.g., 5-10 µm.

Fig. 7B illustrates a three-layer electric shield 100 arrangement (e.g., of a bushing), while Fig. 7C highlights the effect of the bounded portions 110 in each electric shield 100 in preventing the formation of eddy currents and thus enabling effective wireless power transfer. In particular, Fig. 7C depicts a WPT system 200 comprising three electric shields 100 arranged such that the bounded portions 110 of the three electric shields 100 are overlapping.

Further, as depicted in Fig. 7C, an efficient magnetic coupling is achieved when the bounded portions 100 extend within an area roughly equal to or greater than the projected coil area on the electric shields 100.

Fig. 7D depicts a configuration utilizing a single intermediate resonator 230 arranged between two electric shields 100. The bounded portions 110 within the electric shields 100 facilitate magnetic field penetration while maintaining effective electromagnetic shielding.

Fig. 7E depicts a configuration utilizing a single electric shield 100 and one intermediate resonator 230. This arrangement is useful in scenarios where a long-distance power transfer or communication is desired. The intermediate resonator 230 hence acts as a repeater, boosting the signal strength and extending the communication range.

The number of intermediate resonators 230 and the number of electric shields 100 can be arbitrarily adjusted to meet the specific requirements of a specific application. In tightly spaced configurations, such as within a bushing, not every intermediate gap may necessitate an intermediate resonator. Conversely, in scenarios or applications requiring extended range or enhanced signal strength, multiple intermediate resonators can be employed. The use of intermediate resonators 230 may thus ensure efficient and reliable power transfer over varying distances and in diverse environments.

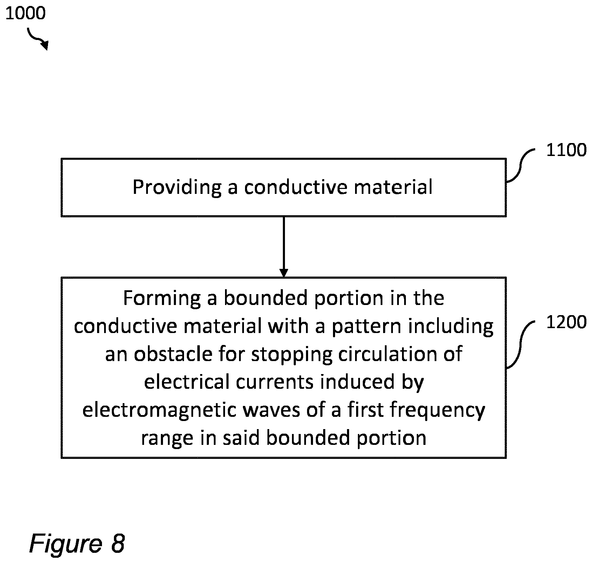

Fig. 8 shows a block diagram of a method 1000 for manufacturing an electric shield, e.g., as discussed in relation to any of Figs. 1-7. In Fig. 8 the method comprises: providing 1100 a conductive material; and forming 1200 a bounded portion in the conductive material with a pattern including an obstacle for stopping circulation of electrical currents induced by electromagnetic waves of a first frequency range in said bounded portion.

Although not explicitly stated in Fig. 8, the conductive material is configured for providing at least one of: an electric equipotential surface, and electric shielding by preventing electromagnetic waves of a second frequency range from passing through the conductive material.

Further, although not explicitly shown in Fig. 8, the method 1000 may further comprise deforming, milling, and/or chemically treating the conductive material in said bounded portion. Hence, a variation in thickness and/or resistivity can be obtained within the bounded portion. In other words, the pattern within the bounded portion may be formed by one or more variations in thickness and/or resistivity.

Generally, manufacturing of the electric shield can be achieved through adaptation of existing shield manufacturing processes, additive manufacturing techniques, or selective material removal/replacement. Such methods may allow for the incorporation of the necessary local material property modifications while maintaining cost-effectiveness and scalability.

Further, although not shown in Fig. 8, it is to be appreciated that the method 1000 may comprise other steps as described and/or realized by the present disclosure, in particular in connection to the description of the preceding figures.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. An electric shield (100) for an electrical device (220), wherein the electric shield (100) comprises a bounded portion (110) comprising a pattern including an obstacle (112) for stopping circulation of electrical currents induced by electromagnetic waves of a first frequency range in said bounded portion (110), wherein the pattern provides anisotropic conductivity within said bounded portion (110) such that electrical currents induced by electromagnetic waves within said bounded portion are directed in one or more specific directions, wherein the electric shield (100) is configured for at least one of:
providing an electric equipotential surface, and
providing electric shielding by preventing electromagnetic waves of a second frequency range from penetrating the electric shield (100).

2. The electric shield according to claim 1, wherein the electric shield provides galvanic contact between any two points on the electric shield.

3. The electric shield according to claim 1 or 2, wherein the pattern in said bounded portion corresponds to a variation in thickness and/or resistivity of a material of the electric shield.

4. The electric shield according to any one of claims 1-3, wherein the pattern comprises at least one local deformation, groove, and/or chemical modification of the material of the electric shield in said bounded portion.

5. The electric shield according to any one of claims 1-4, wherein the electromagnetic waves of the first frequency range include mid-frequency electromagnetic waves, preferably in a range of 5 kHz to 20 MHz, more preferably 10 kHz to 10 MHz.

6. The electric shield according to any one of claims 1-5, wherein the obstacle is one or more anisotropic resistive elements extending in one or more directions along a surface of the electric shield to disrupt the formation of closed-loop currents within said bounded portion.

7. The electric shield according to any one of claims 1-6, wherein the pattern includes one or more obstacles configured to define one or more preferred trajectories for induced currents within the bounded portion, wherein the one or more obstacles are configured as one or more: lines, straight lines, broken lines, cross-shapes, star-shapes, and/or V-shapes within the bounded portion, and wherein the one or more preferred trajectories are substantially non-circular paths.

8. A wireless power transfer, WPT, system 200 comprising:
a power source (210) coupled to an emitter (212);
an electrical device (220) comprising a receiver (222); and
an electric shield (100) according to any one of claims 1-7, wherein said electrical device (220) is at least partly covered by said electric shield (100);
wherein the emitter (212) is configured to transfer electric power from the power source (210) to the receiver (222) of the electrical device (220) via said bounded portion (110) of said electric shield (100).

9. The WPT system according to claim 8, wherein the emitter and receiver are arranged on opposite sides of the electric shield along a transmission trajectory, and wherein the transmission trajectory at least partly intersects the bounded portion of said electric shield.

10. The WPT system according to claim 8 or 9, wherein the WPT system comprises a plurality of electric shields, wherein the plurality of electric shields are arranged such that the bounded portions of the plurality of electric shields are at least partly overlapping.

11. The WPT system according to any one of claims 8-10, wherein the electrical device is a component configured to receive power via electromagnetic waves of the first frequency range.

12. The WPT system according to any one of claims 8-11, wherein the electrical device is further configured to receive and/or transmit information via said electromagnetic waves of said first frequency range.

13. The WPT system according to any one of claims 8-12, wherein the emitter is an emitter coil or antenna configured to transfer electric power via magnetic resonance, and/or wherein the receiver is an LC-resonator.

14. A method (1000) for manufacturing an electric shield according to any one of claims 1-7, the method (1000) comprising:
providing (1100) a conductive material; and
forming (1200) a bounded portion in the conductive material with a pattern including an obstacle for stopping circulation of electrical currents induced by electromagnetic waves of a first frequency range in said bounded portion,
wherein the conductive material is configured for providing at least one of:
an electric equipotential surface, and
electric shielding by preventing electromagnetic waves of a second frequency range from passing through said conductive material.

15. The method according to claim 14, wherein the pattern corresponds to a variation in thickness and/or resistivity, wherein the variation in thickness and/or resistivity is obtained by deforming, milling, and/or chemically treating the conductive material in said bounded portion.
